# EUROPEAN PATENT APPLICATION

(11) **EP 3 145 285 A1**
(43) Date of publication of application: **22.03.2017**
(21) Application number: 15186053.3
(22) Date of filing: 21.09.2015
(51) Int. Cl.: H05K 5/06, B66B 11/00

(54) **DUST PROTECTED ELEVATOR DRIVE**

(71) Applicant: Kone Corporation, 00330 Helsinki (FI)
(72) Inventor: Raassina, Pasi, 04660 Numminen (FI)
(74) Representative: Papula Oy

(57) **Abstract**

Elevator drives are components that are exposed to dust and impurities. These drives typically include electronic components that need to be protected from dust and impurities. This can be achieved by placing the electronic components on a multiple layer circuit board so that they can be separated from the open space. This is provided by having a sealable opening through which the circuit board extends. Connectors to the external cables are provided outside the tight casing. The surface of the circuit board has an empty area at the sealable opening. The conductive tracks from electronic components to the connectors are arranged to layers located inside the multiple layer circuit board.

## Description

### BACKGROUND

In the following a dust protected elevator drive will be discussed. Elevator drives are devices that are used to control the movement of an elevator by providing electricity to the stators of a hoisting machine in a manner that a traction sheave of the hoisting machine starts to rotate. Drives are devices comprising electronic equipment to which dust and other impurities may cause oxidization, corrosion and other defects. It is desirable that the drive is long lasting and does not need to be changed because of a failure.

During recent years the space requirements have led into implementations without machine room. In these cases the hoisting machine and typically also the drive are located in the elevator shaft. Thus, they are more exposed to the environment and impurities in the environment. This is particularly the case, wherein in the drive and hoisting machine are located in the pit below the elevator as the impurities tend to fall into the bottom of the elevator shaft. The exposure is problem particularly when there is more dust, dirt and impurities as metal particles present, for example because of renovations made to the building.

Even if the drive and hoisting machine are more protected in conventional machine room implementations defects can be caused because of a same reason. This is caused by the fact that the machine rooms are not air-tight and the openings to an elevator shaft are a source for impurities. Particularly the ropes moving in the openings bring impurities to the machine room. Also construction and reparation work performed in the machine room may cause dust problems.

A conventional solution for protecting electronic circuits in elevator drives is to provide a protective layer on a circuitry, for example, by using varnish. However, this is expensive and difficult to determine if the protective layer is really protecting the critical components of the circuit.

In some other fields of technology air-tight or hermetic casings are used for protecting against moisture and impurities. In such implementations components, such as computers, circuit boards and similar, are installed inside the casing. In order to keep casings air-tight special purpose connectors need to be used. Used connectors need to be implemented in a manner the connection does not leak. These connectors are complex in design particularly in those cases wherein the connectors are such that the electric wires and cables connected to the connecters can also be easily removed. For example, automotive industries are using such casings and connectors, however, because of a completely different operating environment they are not suitable for elevators without changes in the design of connectors, casings and elevators. For example, these differences include lower operating voltages, exposure to different temperatures, exposure different types of impurities, different kind of exposure to mechanical movement and similar.

### SUMMARY

Elevator drives are components that are exposed to dust and impurities. These drives typically include electronic components that need to be protected from dust and impurities. This can be achieved by placing the electronic components on a multiple layer circuit board so that they can be separated from the open space. This is provided by having a sealable opening in a casing through which the circuit board extends. Connectors to external cables are provided outside the tight casing. The surface of the circuit board has an empty area at the sealable opening. The conductive tracks from electronic components to the connectors are arranged to layers located inside the multiple layer circuit board.

In an embodiment an apparatus is disclosed. The apparatus comprises a multiple layer circuit board, wherein the circuit board is divided into a first portion and a second portion, wherein the first portion comprises electronic components of the drive and the first portion is arranged into a tight casing and the second portion comprises connectors for external wires, wherein the electronic components are connected to the connectors by conductive tracks. The multiple layer circuit board further comprises a third portion between the first and second portions, wherein the surface of the third portion is free of electronic components. The conductive tracks between the electronic components located on first portion and the connectors located on second portion are arranged into layers located inside the multiple layer circuit board. The casing further comprises an opening in a wall, wherein the multiple layer circuit board is configured to extend through the opening in the wall so that the second portion is located outside the casing and the third portion is located at the opening so that it extends to both sides of the wall. The apparatus further comprises a sealing between the third portion of the multiple layer circuit board and the opening in the wall.

In a further embodiment the second portion is arranged into a casing and the wall between the first portion and second portion is one wall of the casing of the second portion. In another embodiment at least one of the casings comprises an openable wall or top cover. In another embodiment the apparatus is an elevator drive. In further embodiment it is used in an elevator system. In a further embodiment the apparatus further comprises a back panel and the back panel further comprises at least one support configured to support electric wires connected to the connectors. In a further embodiment the apparatus comprises passive heat removing element. The element may extend to the exterior of the casing. In another embodiment the apparatus further comprises a fan configured to distribute the heat inside the casing. In a further embodiment a fan is provided outside the casing and configured to distribute a forced convection to transfer heat from the outer wall of the casing.

The benefits of described embodiments include providing a cost efficient dust proof protection for an elevator drive. An additional benefit of the disclosed elevator drive is that it does not require changes to other components, such as connectors and electric cables. Thus, an old elevator drive that needs to be changed can be easily replaced by the disclosed elevator drive. A further benefit of the disclosed elevator drive is that it can be manufacture in different levels of tightness. Thus, an air-tight option can be easily manufactured. Using the disclosed elevator drive provides benefits in elevator maintenance by reducing defects and thus reducing costs. Furthermore, the protective casing of the disclosed elevator drive extends the life time of electronic components located inside the casing as the electronic components are not exposed to dust and impurities.

A further benefit of described embodiments includes a possibility to easily manufacture casings or enclosures which fulfill industry standards. For example, IP54 protection and similar, that are well known to a person skilled in the art.

### BRIEF DESCRIPTION OF THE DRAWINGS

The accompanying drawings, which are included to provide a further understanding of the dust protected elevator drive and constitute a part of this specification, illustrate embodiments and together with the description help to explain the principles of the dust protected elevator drive. In the drawings:
**Fig. 1** is a block diagram of an example embodiment illustrating an elevator system,
**Fig. 2** is a top-view of an example embodiment, and
**Fig. 3** is a side-view of an example embodiment.

### DETAILED DESCRIPTION

Reference will now be made in detail to the embodiments, examples of which are illustrated in the accompanying drawings.

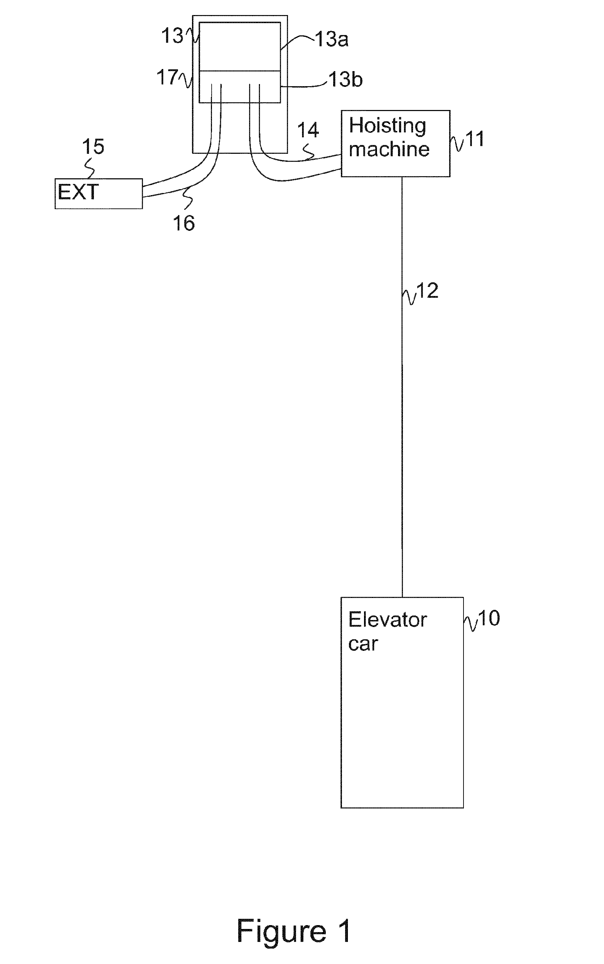

In figure 1 an example embodiment of a dust protected elevator drive is disclosed. In the embodiment a common configuration is disclosed. In the embodiment of figure 1 an elevator car 10 is connected to a hoisting machine 11 by hoisting ropes 12. In the figure the details of the hoisting machine and elevator configuration are not shown. One commonly used configuration is to use an electric motor and a counter-weight for operating the elevator. These are very well known to a person having ordinary skill in the art of elevators and not explained in detail.

The hoisting machine 11 is further connected to a drive 13 by electric wires 14. Electric wires 14 are used provide electricity to the electric motor located in the hoisting machine 11, however, it is possible to include also other electric cables or other cables, for example, for providing data communications between the hoisting machine 11 and the drive 13. The drive is further connected to the external systems 15 by external wires 16. These systems include, for example, a connection to controller controlling the elevator system, a connection to electricity source and similar. The wires 16 may include electric wires, optical fibers and any other wire types that may be used when operating an elevator. Wires used may be different in size and weight. In figure 1 it can be seen that the drive 13 is located on a back panel 17 that may be used for attaching the drive unit to a wall, column or other support structure. In figure 1 it can be seen that the drive 13 is formed of portions. The first portion 13a hosts the electronic components and other components that need to be protected. The second portion 13b comprises connectors for wires 14 and 16. There is a wall between the portions. Details of the wall will be explained in below.

The drive 13 is typically arranged into a casing that comprises a circuit board on which the electronic components are arranged. The casing may be tight between the walls of the casing and the back panel 17. Correspondingly the casing typically comprises a top plate that is arranged on the top of the drive so that the casing is dust protected with exception of the openings for wires 14 and 16 as well as openings for possible fan inside the casing. There are different levels of tightness, however, the seams between the back panel, walls and top plate can be made air-tight. Furthermore, there are different standards for determining the capabilities of casings or enclosures for electronic components. These standards typically include also information regarding the protective characteristics. The casing of the drive may be designed according to these properties.

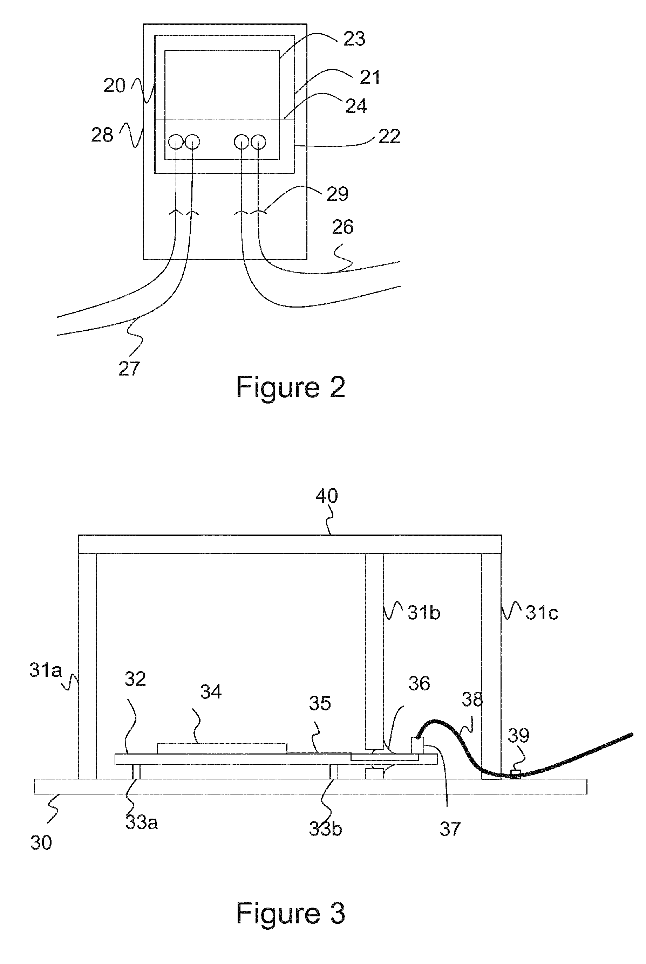

In figure 2 an example embodiment is disclosed. The embodiment of figure 2 is a drive 20. The drive comprises a first portion 21 and a second portion 22. Inside the drive is a circuit board 23. The circuit board extends from the first portion 21 to the second portion 22. Between the first portion 21 and the second portion 22 there is a partitioning wall 24 that is arranged so that the circuit board 23 extends through the wall 24. The circuit board 23 is a multiple layer circuit board. Multiple layer circuit board includes conductive tracks also inside the board so that there may be a plurality of conductive tracks on different layers. As the conductive tracks do not have contact with conductive tracks on other layers the designer has more freedom to design the tracks. In the drive 20 figure 2 there are no components on the circuit board 23 in the vicinity of the partitioning wall 24. In the vicinity of the partitioning wall all conductive tracks are inside the circuit board 23. Thus, the surface of the circuit board 23 is free of components in the vicinity of the partitioning wall 24. This allows sealing the opening in the partitioning wall 24 through which the circuit board 23 extends from the first portion 21 to the second portion 22. Thus, it is possible to seal first portion tightly, even air-tight if necessary. In some other embodiments at least one of conductive tracks is formed on the surface of the circuit board 23 in the vicinity of the partitioning wall 24. This may be possible if there is no risk of short circuit, for example if the partitioning wall is made of electrically isolating material, such as polyurethane. The circuit board 23 comprises connectors 25 for different kind of wires 26, 27. The connectors 25 are located in the second portion 22 of the drive casing.

Wires 26, 27 to external systems and hoisting machine extend out of the casing of the drive 20 through holes or other opening that need not to be sealed but they may include some protection for keeping at least some of impurities out of the casing so that the connectors 25 are kept in good shape. However, it is possible to manufacture connectors that are not as vulnerable as electronic components on the circuit board 23. Thus, the same level of protection is not needed.

The drive 20 is attached to a bottom plate or a back panel 28. The back panel 28 is used for attaching the drive 20 to a wall or other support structure. In addition to the drive 20 and attachment means the back panel 28 may comprise additional supports 29 for supporting the wires. As shown in figure 2 the wires may be attached so that they extend downwards from the connectors 25. Thus, the weight of a wire causes a force to the respective connector. In some cases the wires 25, 26 may be heavy and need to be supported so that the force caused by the gravity is minimized at the respective connector. It is possible to used different kinds of supports, such as hooks, clamps, rings or other support means so that the weight rests mainly on the support instead of hanging from the connector. This will reduce the stress caused to the connectors 25 and the circuit board as whole 23.

The connectors 25 may be connectors of any suitable type, for example, molex-type electric connectors. Furthermore, if there is a need for connectors of different type, for example, for optical fibers, there needs to be a converter provided at the connectors so that the conductive paths can be used for providing the connection.

The drive inside casing generates heat. If the heat is local then a fan may be used for distributing the heat in the casing so that the heat generating location is cooler. The purpose of the inside cooler is to remove heat from a single point, such as a processor, to the environment inside the casing.

Furthermore, it is possible to mount passive heat removing elements, for example metal bars extending through or to the casing so that the heat is transferred from the heat generating element. For example, in case of a processor there may be a passive heat removing element on the processor. The heat cooling element may be connected to a metal wall of the casing so that the heat is conducted to the wall of the casing. In such case, it is possible to arrange a fan outside the casing so that the air flow cools down the wall to which the heat is conducted. The cooling arrangements mentioned above are only examples and they may be combined and the combination may be chosen according to the application needs. Also other cooling mechanisms may be used, provided that they do not need openings through which impurities could enter the casing.

Figure 3 discloses a side view of a dust protected drive. The drive is arranged on a back panel 30, to which outer walls 31a, 31c and the partitioning wall 31b have been attached. In the embodiment the side wall 31a does not have any openings. Side wall 31c has openings for electric wires 38. The openings may be simple unsealed openings. The partitioning wall 31b comprises an opening that is large enough for circuit board 32. The circuit board 32 is attached to the back panel by using feet 33a, 33b. The purpose of the feet is to provide a small distance between the circuit board 32 and the back panel 33. Such feet 33a, 33b are well known, for example, in computer industry. The back panel 30 and walls 31 may be made of any suitable material and they may be made of one piece or from several pieces and then attached together. For example, it is possible to mount walls 31 to the back panel 30. Typically the mounting is done tight enough to keep impurities and dirt outside the walls. In the figure On the top of walls 31 is a top plate 40 that is mounted tightly and may be further sealed after closing.

Electronic components 34 of the drive are located on the circuit board 32. As explained above the circuit board 32 comprises multiple layers and conductive tracks 35 can be located on or inside the circuit board 32. As it can be seen in the figure the conductive track 35 is on the circuit board 32 where it leaves the electronic components 34 and goes inside the circuit board 32 before the partitioning wall 31b. Around the location of the partitioning wall there is an empty space on the circuit board 32. The empty space is arranged by placing all conductive tracks 35 inside the circuit board 32 near the partitioning wall 31b. The dimensions of the empty space depend on the thickness of the partitioning wall 31b and the used sealing material. In the embodiment of figure 3 sealing material 36 is used to make the hole, through which the circuit board 32 extends, tight. The sealing material may be, for example, silicone caulk or any other suitable sealing material. In the figure the sealing material is visible on the top and under of circuit board 32, however, it is obvious that also the sides are sealed so that the dust and impurities cannot pass through the hole.

As explained above, there needs to be a component and conductive track free area on the circuit board 32. The dimensions of the free area are determined by the thickness of the wall and the space that is needed for the sealing material. Thus, the thickness of the wall 31b and the free area on the circuit board 32 need to be designed together. In the free area all conductive tracks must be inside the circuit board 32. On the other side of the partitioning wall 31b are the connectors 37 to which the wires 38 are attached to. The conductive tracks may be re-surfaced at the connectors 37 or before. In the embodiment of figure 3 there are additional supports 39 for wires so the gravity or other outside forces do not cause stress to the connectors 37.

In the examples above a dust protected elevator drive having two closed portions is described, however, only the first portion needs to be protected. Thus, for example in figure 3, the wall 31c is optional. Without the wall 31c the connectors 36 are in the open space. It is not discussed above but the walls and/or the top panel may comprise openable portions which are necessary for maintenance. These openable portions are such that the can be again tightly closed.

In the above a tight drive arrangement has been discussed. The level of tightness is chosen according to the need of the application. In elevator environment typically dust-tight is enough, however, it is possible and in some applications desirable to make the arrangement air-tight.

It is obvious to a person skilled in the art that with the advancement of technology, the basic idea of the dust protected elevator drive may be implemented in various ways. The dust protected elevator drive and its embodiments are thus not limited to the examples described above; instead they may vary within the scope of the claims.

## Claims

1. An apparatus comprising:
a tight casing;
a multiple layer circuit board, wherein said circuit board is divided into a first portion and a second portion, wherein
said first portion comprises electronic components of said drive and said first portion is arranged into said tight casing;
said second portion comprises connectors for external wires, wherein said electronic components are connected to said connectors by conductive tracks; wherein
said multiple layer circuit board further comprises a third portion between said first and second portions, wherein the surface of said third portion is free of electronic components;
said casing further comprises an opening in a wall, wherein said multiple layer circuit board is configured to extend through said opening in said wall so that said second portion is located outside the casing and said third portion is located at said opening; and
said apparatus further comprises a sealing between said third portion of the multiple layer circuit board and said opening in said wall.

2. An apparatus according to claim 1, wherein said conductive tracks between said electronic components of the first portion and said connectors of the second portion are arranged in the third portion into layers located inside the multiple layer circuit board.

3. An apparatus according to claim 1 or 2, wherein said second portion is arranged into a non-sealed casing and said wall between the first portion and second portion is one wall of the casing of the second portion.

4. An apparatus according to any of preceding claims , wherein at least one of the casings comprises an openable wall or top cover.

5. An apparatus according to any of preceding claims 1 - 4, wherein said apparatus further comprises a back panel.

6. An apparatus according to claim 5, wherein said back panel comprises at least one support configured to support electric wires connected to said connectors.

7. An apparatus according to any of preceding claims 1 - 6, wherein said apparatus further comprises a passive heat removing element or a heat sink.

8. An apparatus according to claim 7 wherein said passive heat removing element or heat sink is formed to a wall of the casing; and
wherein the electronics components of the first portion include at least one power semiconductor coupled to the casing in a manner enabling transfer of heat from the power semiconductor to the casing.

9. An apparatus according to any of preceding claims 1 - 8, wherein said apparatus further comprises a fan configured to distribute a forced convection to transfer heat from the outer wall of the casing.

10. An apparatus according to any of preceding claims 1 - 9, wherein said apparatus further comprises a and configured to distribute air inside said tight casing.

11. An apparatus according to any of preceding claims 1 - 10, wherein said apparatus is an elevator drive.

12. An elevator comprising an apparatus according to any of preceding claims 1 - 11.
